# FASCICULE DE BREVET EUROPEEN

(11) **EP 1 154 047 B1**
(45) Date de publication et mention de la délivrance du brevet: **08.02.2012**
(21) Numéro de dépôt: 01410052.3
(22) Date de dépôt: 11.05.2001
(51) Int. Cl.: C30B 11/00, C30B 29/06, C30B 28/06

(54) **Installation et procédé de fabrication en continu de barreau de silicium multicristallin**
Vorrichtung und Verfahren zur kontinuerlichen Herstellung von polykristallinen Siliziumstäben
Apparatus and process for the continuous fabrication of a polycrystalline silicon ingot

(30) Priorité: 11.05.2000 FR 0006027
(43) Date de publication de la demande: 14.11.2001
(73) Titulaire: Emix, 38610 Gieres (FR)
(72) Inventeur: Garnier, Marcel, 38410 Saint Martin d'Uriage (FR); Kaneko, Kyojiro, c/o EPM Madylam, 38402 Saint Martin d'Heres, Cedex (FR); Ribeyron, Pierre-Jean, 38920 Crolles (FR)
(74) Mandataire: de Beaumont, Michel

(56) Documents cités:
- EP-A- 0 477 784
- US-A- 4 134 785
- US-A- 4 838 933
- US-A- 5 373 807
- PATENT ABSTRACTS OF JAPAN vol. 014, no. 220 (C-0717), 10 mai 1990 (1990-05-10) & JP 02 051493 A (OSAKA TITANIUM CO LTD), 21 février 1990 (1990-02-21)
- DOUR G ET AL: "Continuous solidification of photovoltaic multicrystalline silicon from an inductive cold crucible" JOURNAL OF CRYSTAL GROWTH,NL,NORTH-HOLLAND PUBLISHING CO. AMSTERDAM, vol. 193, no. 1-2, 15 septembre 1998 (1998-09-15), pages 230-240, XP004142236 ISSN: 0022-0248

## Description

La présente invention concerne la fabrication de silicium multicristallin.

Des plaquettes de silicium multicristallin sont utilisées en particulier pour des applications photovoltaïques permettant de transformer l'énergie solaire en énergie électrique. On cherche alors à réaliser des plaquettes minces, par exemple des carrés 12,5 cm de côté et d'environ 0,5 mm d'épaisseur, par sciage de barreaux de grandes longueurs dont les dimensions latérales sont des multiples des dimensions latérales recherchées des plaquettes.

Un dispositif de fusion et de coulée continue de métaux est décrit par exemple dans le brevet américain 4 838 933 de Patrick Paillere, Edouard Alheritiere, Marcel Garnier, Jean Driole et Annie Gagnoud. Ce brevet vise essentiellement la coulée de métaux.

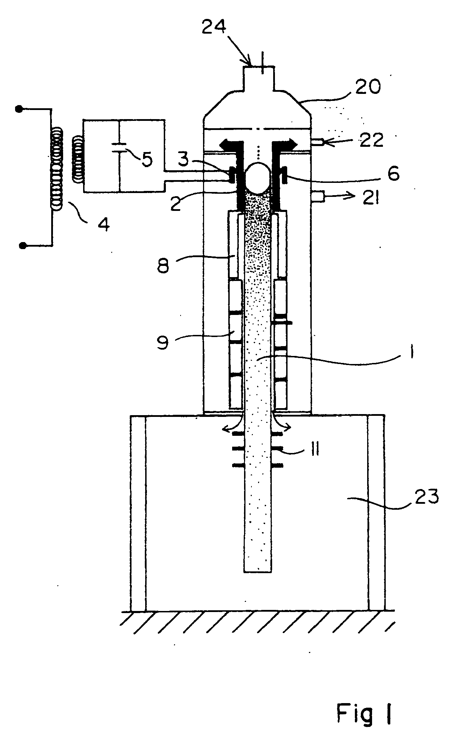

Une application du dispositif décrit dans ce brevet à une installation de fabrication de silicium multicristallin est illustrée de façon schématique en figure 1. Cette installation est représentée en cours de fonctionnement. Un barreau de silicium 1 sort d'un cylindre correspondant à un empilement de creusets et de fours cylindriques. La partie supérieure est un four à induction comprenant un creuset à parois froides 2 chauffé par un enroulement 3 excité à fréquence moyenne, par exemple par l'intermédiaire d'un transformateur 4 dont le secondaire est couplé à l'enroulement 3 en parallèle avec un condensateur 5. Le système de chauffage à induction est réglé pour que la partie supérieure 6 du barreau soit à l'état liquide. Sous le four à induction 2 est disposé un four à gradient de température 8 sous lequel se trouve un four de recuit 9. La partie inférieure du barreau est entraînée par des griffes 11 reliées à un système d'entraînement lent non représenté. L'ensemble des fours est disposé dans une cloche étanche 20 qui comporte une ouverture de pompage 21, ainsi qu'un orifice d'entrée de gaz 22, par exemple de l'argon. La chambre inférieure 23 dans laquelle débouche le barreau est par exemple à atmosphère ambiante. L'argon est en surpression dans la cloche 20 et s'échappe entre le barreau 1 et les parois internes des divers fours vers la chambre 23. Il est également prévu divers dispositifs d'introduction de matière, par exemple une entrée supérieure d'introduction de billes de silicium de qualité métallurgique 24. La partie haute de la cloche peut éventuellement être associée à une torche à plasma pour amorcer le fonctionnement du dispositif et pour préchauffer les billes de silicium introduites.

L'installation ci-dessus ne sera pas décrite plus en détail car elle est connu de l'homme du métier et a par exemple été décrite dans Proceedings of the International Congress on Electromagnetic Processing of Materials, juin 1997, vol. 2, pp 303-308, P-J Ribeyron, A. Gagnoud, M. Anderhuber, G. Dour, F. Durand. et dans le brevet européen EP-A-0477784.

Pour initialiser le fonctionnement de l'installation de la figure 1, on introduit un barreau de silicium témoin lié à une tige de traction, on chauffe la partie supérieure de silicium par la torche à plasma pour provoquer la fusion initiale puis on met en route les fours et notamment le four à induction 2. Ensuite, le barreau est tiré régulièrement vers le bas tandis que l'on introduit des grains de silicium métallurgique par l'entrée haute 24.

Le fonctionnement d'une telle installation est inévitablement semi-continu. En effet, quand on a tiré une hauteur de barreau correspondant sensiblement à la hauteur de la chambre de dégagement 23, il faut arrêter les opérations pour procéder à un sciage. En effet, un barreau de silicium ne peut être fléchi et enroulé, comme cela est suggéré pour des métaux dans le brevet susmentionné.

La présente invention vise à prévoir une telle installation permettant une coulée réellement continue.

Pour atteindre cet objet, la présente invention prévoit une installation de fabrication en continu d'un barreau de silicium multicristallin dans un creuset sensiblement cylindrique. Le creuset est chauffé dans sa partie haute par induction de façon que la partie supérieure de silicium soit fondue et est associé à des moyens de réalimentation en silicium. Cette installation comprend des moyens pour aspirer périodiquement une partie du silicium fondu.

Selon un mode de réalisation de la présente invention, la partie aspirée de la phase fondue correspond à environ 30 à 70 % du volume de cette phase, de préférence 30 à 50 %.

Selon un mode de réalisation de la présente invention, l'aspiration est réalisée par l'intermédiaire d'une canne rétractable.

Selon un mode de réalisation de la présente invention, la canne est montée dans une gaine chauffante de façon amovible, facilement démontable et jetable.

Selon un mode de réalisation de la présente invention, l'installation comprend un système de tirage du barreau de silicium associé de façon débrayable à une monture de scie de sorte que, quand la scie est en action, elle se déplace verticalement comme le barreau.

Selon un mode de réalisation de la présente invention, la scie est une scie circulaire diamantée associée à des moyens d'aspersion d'eau.

Selon un mode de réalisation de la présente invention, la réalimentation en silicium est faite en silicium de qualité métallurgique.

La présente invention prévoit aussi un procédé d'utilisation d'une installation du type ci-dessus consistant à utiliser les mêmes paramètres de réglage de l'installation et à faire varier la section interne du creuset cylindrique pour passer d'une section carrée à des sections rectangulaires dont le plus petit côté est égal au côté du carré.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une installation classique de coulée semi-continue de silicium multicristallin ;
les figures 2A et 2B représentent un système d'extraction de parties liquides selon la présente invention dans deux positions de fonctionnement ; et
la figure 3 représente un système de sciage de barreau selon la présente invention.

Selon un premier aspect de l'invention, la demanderesse a réalisé des installations expérimentales dans lesquelles la hauteur de la chambre dans laquelle on tirait un barreau de silicium multicristallin était très élevée (plusieurs mètres) de façon à augmenter la durée d'une opération de coulée. Toutefois, la demanderesse s'est aperçue que la concentration en impuretés dans le barreau augmentait et que la qualité du silicium multicristallin obtenu se dégradait.

La demanderesse a analysé ce phénomène en utilisant du silicium métallurgique d'une pureté telle qu'aucune impureté métallique n'est présente à une concentration supérieure à une partie par million (ppm) et qu'il existe tout au plus 2 à 5 ppm de carbone et moins de 10 ppm d'atomes d'oxygène. On observe alors dans le lingot, au début du processus, une concentration inférieure à 10 parties par milliard (ppM) de chacune des impuretés métalliques, une concentration en atomes d'oxygène inférieure à 1 ppm et une concentration en atomes de carbone sensiblement égale à la concentration initiale (2 à 5 ppm). Ceci est dû à un effet de ségrégation des impuretés entre les phases liquide et solide pendant la solidification du silicium. Toutefois la concentration en impuretés dans la zone en fusion augmente au cours du temps et, tandis qu'elle augmente, malgré l'effet de ségrégation, la concentration en impuretés dans le barreau de silicium augmente également.

Ainsi, la présente invention prévoit, pour permettre d'augmenter la durée d'une coulée, d'éliminer périodiquement, par pompage, une partie de la phase liquide de silicium se trouvant à la partie supérieure du barreau. Le volume de cette phase liquide redevenant constant en raison du chauffage peu après l'extraction, on divise ainsi à chaque opération de pompage la concentration en impuretés (essentiellement en impuretés métalliques). On évitera de pomper lors de chaque opération plus de la moitié du volume de la phase liquide pour empêcher la partie supérieure du lingot de se fissurer par suite d'un changement brutal des conditions thermiques. On choisira un pompage de 30 à 70 % du volume de la phase liquide, de préférence 30 à 50 %, mais la quantité pompée dépendra du volume de la phase liquide. Elle sera de préférence prélevée dans la partie supérieure de la zone liquide.

La présente invention prévoit également un moyen pour assurer ce pompage d'une partie de la phase liquide de façon relativement rapide pour ne pas gêner le fonctionnement du système et ne pas être obligé d'interrompre d'autres éléments en fonctionnement, par exemple le système d'alimentation en billes de silicium. Tout ou plus, après chaque aspiration, on pourra interrompre le tirage et augmenter momentanément le débit de billes de silicium fournies à l'installation.

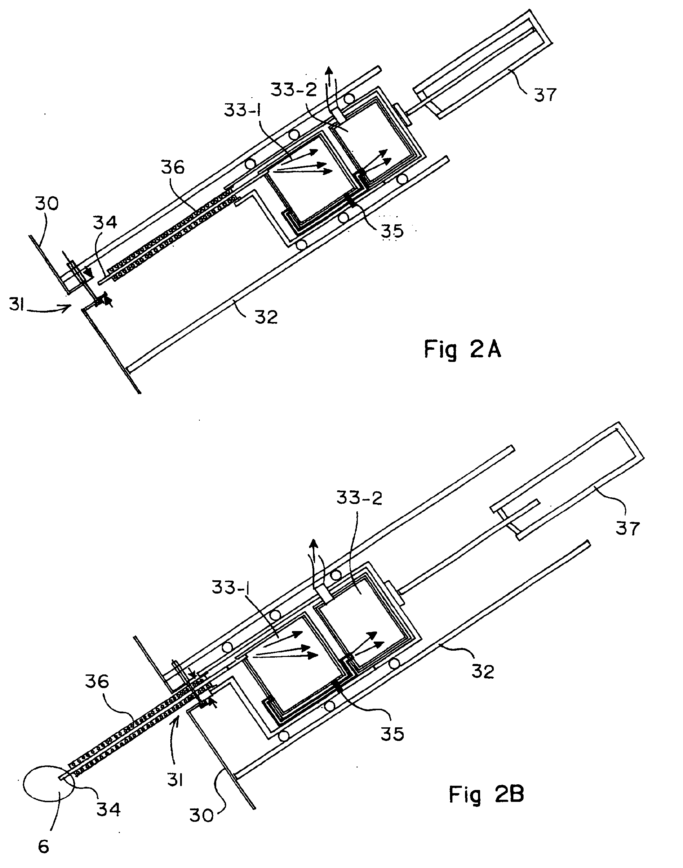

Les figures 2A et 2B représentent de façon schématique un mode de réalisation d'un dispositif d'aspiration de phase liquide dans deux états de fonctionnement. Ce dispositif est monté par une plaque 30 sur la cloche 20 mentionnée en figure 1. Une ouverture 31 dans cette plaque correspond à une ouverture dans la cloche en regard de la phase liquide 1 à la partie supérieure du barreau 1. Une première enceinte 32 contient des chambres 33-1 et 33-2 mobiles par rapport à cette enceinte. La chambre 33-1 est reliée à une canne d'aspiration 34 et, par l'intermédiaire d'une vanne 35, à la chambre 33-2. Un vérin 37 permet de pousser les chambres de sorte que la canne 34 sort par l'ouverture 31, dans la position représentée en figure 2B, l'extrémité de la canne venant alors pénétrer dans la zone fondue 6.

On aura de préférence fait au préalable le vide dans la chambre 33-2 et, dès que l'extrémité dé la canne 34 pénètre dans la zone liquide, on ouvre la vanne 35 entre les deux chambres 33-1 et 33-2, de sorte qu'une quantité prédéterminée de silicium liquide est aspirée par la canne 34 et vient se loger dans la première chambre 33-1 dont l'intérieur est de préférence en graphite.

Bien entendu, on prendra diverses précautions pour ne pas perturber le fonctionnement de l'installation de coulée. Notamment, l'intérieur de l'enceinte 32 sera mis au préalable à une température et sous une atmosphère convenable. De même, la canne 34 aura été au préalable chauffée, par exemple par un fourreau 36 chauffé par des résistances électriques entourant la canne.

Dès qu'une opération d'aspiration est effectuée, la canne est rétractée sous l'action du vérin 37, la chambre 32 est refermée, et la canne 34 est remplacée. En effet, après chaque opération, cette canne, par exemple en silice, est obturée par une partie au moins du silicium aspiré. La monture de la canne 34 à l'intérieur du fourreau et son montage en liaison avec le fourreau et la chambre 33-1 sont réalisés de façon que cette canne puisse facilement être enlevée et remplacée.

Ainsi, cette première disposition selon la présente invention permet de prolonger la durée des coulées. Toutefois, on se heurte au problème énoncé précédemment selon lequel, dans l'installation de la figure 1, on est obligé d'interrompre les opérations dès que la hauteur du barreau devient égale à la hauteur de la chambre inférieure. En outre, il n'est pas commode de prévoir des chambres de recueil 23 de très grande hauteur.

Pour pallier ces inconvénients, la présente invention prévoit de scier périodiquement des portions du barreau de silicium chaque fois que la longueur du barreau de silicium se rapproche de la hauteur de la chambre inférieure, sans perturber le fonctionnement de l'installation.

Pour cela, la présente invention prévoit de monter une scie de découpe du barreau sur un élément se déplaçant en même temps que le barreau de façon que le mouvement relatif vertical entre le barreau et la scie soit nul.

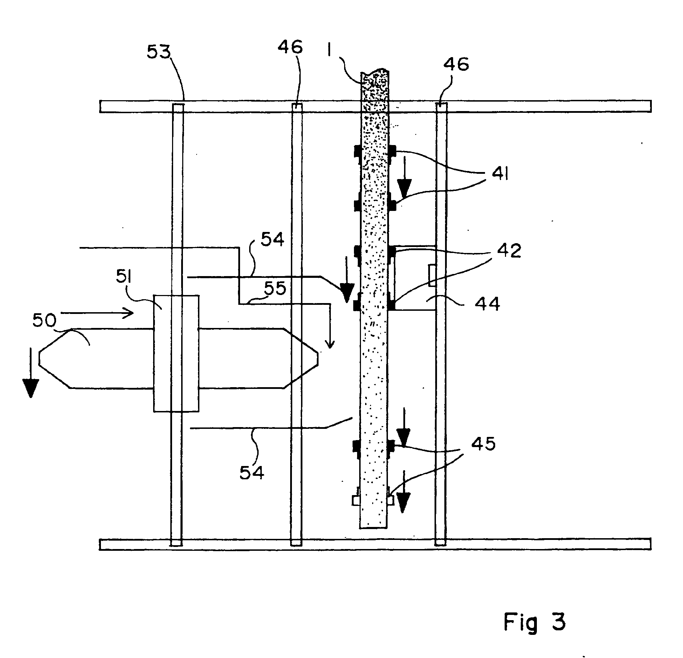

La figure 3 représente un mode de réalisation particulier de cet aspect de l'invention.

La figure 3 représente une partie inférieure du barreau 1 prise entre trois ensembles de griffes 41, 42 et 43. Chaque ensemble de griffes est solidaire d'un chariot dont un seul, 44, est représenté. Ce chariot s'appuie par exemple sur des vis sans fin 46 entraînées simultanément. Ainsi, le barreau 1 est entraîné régulièrement vers le bas. Une scie circulaire diamantée 50 est montée sur une embase 51 qui peut s'engrener sur une vis sans fin 53 tournant en même temps que les vis 46. Dans les phases de coupe, l'embase de la scie est engrenée sur la vis sans fin 53 et ainsi elle descend à la même vitesse que le barreau. Des moyens mécaniques sont prévus pour déplacer la scie et la mettre en appui contre le barreau pendant sa descente simultanée avec le barreau. Une fois que la portion inférieure du barreau a été sciée, la scie est débrayée et remise à sa position initiale jusqu'à la prochaine découpe. La figure 3 est extrêmement schématique. La scie est bien entendu disposée de façon à ne pas interférer avec les autres éléments mécaniques du système. Notamment, bien que, pour simplifier la figure, la vis sans fin 53 soit représentée sur le côté gauche de la figure, en fait, elle sera disposée par exemple vers l'avant. Une fois que la scie a réalisé son opération, les griffes inférieures 43 sont désengagées de la partie coupée du barreau et sont déplacées vers le haut. Avec un système à trois ensembles de griffes, on pourra réarranger les griffes de façon souhaitée.

De préférence, la partie active de la scie, quand elle vient couper le barreau est entourée d'un carter 54 et il est prévu une conduite 55 pour projeter de l'eau sur la scie de façon à faciliter la découpe et augmenter la durée de vie de la scie.

On notera que cette opération de sciage périodique du barreau obtenu par coulée continue n'est pas un inconvénient dans le cas d'un barreau de silicium multicristallin étant donné que ce barreau est ensuite destiné à être coupé en tranches minces et non pas à être utilisé comme un barreau de grande longueur.

Selon un troisième aspect de la présente invention, pour améliorer la rentabilité d'un système de coulée continue, on vise à augmenter la taille des barreaux de coulée. Les inventeurs ont constaté que, si l'on veut augmenter la section d'un lingot de section carrée, tous les paramètres du système sont à revoir, et notamment tous les paramètres du système d'induction, pour conserver un équilibre entre phases solide et liquide et un asservissement convenable. Ainsi, si un système a été conçu pour fonctionner avec un barreau de 280x280 mm de façon à permettre d'obtenir par sciage, en tenant compte des chutes quatre plaquettes de 125x125 mm par tranche du barreau, il est très difficile de refaire un nouveau système permettant par exemple d'augmenter les dimensions latérales du carré de 50 % pour permettre d'obtenir par sciage neuf tranches au lieu de quatre. Alors, tous les paramètres du système devront être reconsidérés et l'on risque fort de se trouver devant des conditions d'instabilité.

Selon cet aspect de la présente invention, les inventeurs ont noté que, par contre, si au lieu de prévoir un barreau carré on prévoit des barreaux rectangulaires dont le petit côté reste de dimension constante, les conditions de fonctionnement du système ne varient pratiquement pas. Ainsi, une machine fonctionnant pour des barreaux de 280x280 mm de côté pourra être réutilisée en changeant simplement la section interne des divers fours mais sans changer les autres paramètres de fonctionnement du système (fréquence et intensité d'alimentation du four à induction, et vitesse de tirage) si l'on passe à des dimensions de barreaux rectangulaires de 280 mm pour le petit côté et de, par exemple, 425 mm, 600 mm, ou plus, pour l'autre dimension. De plus, on s'aperçoit que non seulement on augmente le volume obtenu par unité de temps mais encore le rendement est amélioré, les défauts devenant plus rares, et notamment les contraintes internes dans le barreau devenant plus faibles pour des barreaux de plus grande section.

La présente invention est susceptible de diverses variantes et modifications qui apparaîtront à l'homme de l'art, notamment en ce qui concerne les vitesses et les détails de réalisation, du moment que l'un au moins des aspects principaux de l'invention est conservé :
- élimination périodique de l'excès de phase fondue en partie supérieure du barreau ;
- sciage à la volée ;
- augmentation d'une dimension transverse du barreau sans toucher à l'autre dimension.

## Revendications

1. Installation de fabrication en continu d'un barreau de silicium multicristallin dans un creuset sensiblement cylindrique (2), ledit creuset étant chauffé dans sa partie haute par induction de façon que la partie supérieure de silicium soit fondue et étant associé à des moyens (24) de réalimentation en silicium, **caractérisée en ce qu'**elle comprend des moyens (30-37) pour aspirer périodiquement une partie du silicium fondu.

2. Installation selon la revendication 1, **caractérisée en ce que** la partie aspirée de la phase fondue correspond à environ 30 à 70 % du volume de cette phase.

3. Installation selon la revendication 2, **caractérisée en ce que** la partie aspirée de la phase fondue correspond à environ 30 à 50 % du volume de cette phase.

4. Installation selon la revendication 1, **caractérisée en ce que** l'aspiration est réalisée par l'intermédiaire d'une canne rétractable (34).

5. Installation selon la revendication 4, **caractérisée en ce que** ladite canne (34) est montée dans une gaine chauffante (36) de façon amovible, facilement démontable et jetable.

6. Installation selon la revendication 1, **caractérisée en ce qu'**elle comprend un système de tirage du barreau de silicium (41-46) associé de façon débrayable à une monture de scie (50) de sorte que, quand la scie (50) est en action, elle se déplace verticalement comme le barreau.

7. Installation selon la revendication 6, **caractérisée en ce que** la scie (50) est une scie circulaire diamantée associée à des moyens d'aspersion d'eau (55).

8. Installation selon l'une quelconque des revendications 1 à 7, **caractérisée en ce que** la réalimentation en silicium est faite en silicium de qualité métallurgique.

9. Procédé d'utilisation d'une installation selon l'une quelconque des revendications 1 à 8, **caractérisé en ce qu'**il consiste à utiliser les mêmes paramètres de réglage de ladite installation et à faire varier la section interne du creuset cylindrique pour passer d'une section carrée à des sections rectangulaires dont le plus petit côté est égal au côté du carré.

## Claims

1. An installation of continuous manufacturing of a multicrystalline silicon bar in a substantially cylindrical crucible (2), said crucible being heated in its high portion by induction so that the upper silicon portion is melted, and being associated with silicon refeeding means (24), **characterized in that** it comprises means (30-37) for periodically sucking a part of the molten silicon.

2. The installation of claim 1, **characterized in that** the sucked-in portion of the molten phase approximately corresponds to from 30 to 70% of the volume of this phase.

3. The installation of claim 2, **characterized in that** the sucked-in portion of the molten phase approximately corresponds to from 30 to 50% of the volume of this phase.

4. The installation of claim 1, **characterized in that** the sucking-in is performed via a retractable tube (34).

5. The installation of claim 4, **characterized in that** said tube (34) is removably assembled in a heating jacket (36), easily detachable and disposable.

6. The installation of claim 1, **characterized in that** it comprises a system for pulling the silicon bar (41-46) releasably assembled to the frame of a saw (50) so that, when the saw (50) is in action, it displaces vertically like the bar.

7. The installation of claim 6, **characterized in that** the saw (50) is a diamond circular wheel associated with water spraying means (55).

8. The installation of any of claims 1 to 7, **characterized in that** the silicon refeeding is performed with metallurgical-grade silicon.

9. A method for using the installation of any of claims 1 to 8, **characterized in that** it uses the same setting parameters of said installation while the internal section of the cylindrical crucible is varied to pass from a square cross-section to rectangular cross-sections having their smaller side equal to the side of the square.

## Patentansprüche

1. Eine Installation zur kontinuierlichen Herstellung einer multikristallinen Siliziumstange in einem im wesentlichen zylindrischen Schmelzgefäß (2), welches in seinem oberen oder höher liegenden Teil durch Induktion erhitzt wird, so dass der obere Siliziumteil geschmolzen wird, und wobei das Schmelzgefäß mit Siliziumrückeinspeisungsmitteln (24) assoziiert ist, **dadurch gekennzeichnet, dass** sie Mittel (30-37) aufweist zum periodischen Absaugen eines Teils des geschmolzenen Siliziums.

2. Installation nach Anspruch 1, **dadurch gekennzeichnet, dass** der ab- bzw. eingesaugte Teil der geschmolzenen Phase annähernd 30 bis 70% des Volumens dieser Phase entspricht.

3. Installation nach Anspruch 2, **dadurch gekennzeichnet, dass** der abgesaugte Teil der geschmolzenen Phase annähernd 30 bis 50% des Volumens dieser Phase entspricht.

4. Installation nach Anspruch 1, **dadurch gekennzeichnet, dass** das Absaugen über ein zurückziehbares Rohr (34) erfolgt.

5. Installation nach Anspruch 4, **dadurch gekennzeichnet, dass** das Rohr (34) entfernbar in einem Heizmantel (36) zusammengebaut ist, und zwar leicht abnehmbar und anordenbar.

6. Installation nach Anspruch 1, **dadurch gekennzeichnet, dass** sie ein System zum Ziehen der Siliziumstange (41-46) aufweist, und zwar lösbar zusammengebaut mit dem Rahmen einer Säge (50) derart, dass dann, wenn die Säge (50) in Betrieb ist, sie sich vertikal versetzt wie die Stange.

7. Installation nach Anspruch 6, **dadurch gekennzeichnet, dass** die Säge (50) eine Diamantkreissäge ist, und zwar assoziiert mit Wassersprühmitteln (55).

8. Installation nach einem der Ansprüche 1 bis 7, **dadurch gekennzeichnet, dass** die Siliziumrückeinspeisung mit Silizium von metallurgischer Qualität erfolgt.

9. Verfahren zur Verwendung der Installation eines der Ansprüche 1 bis 8, **dadurch gekennzeichnet, dass** es die gleichen Einstellparameter der Installation verwendet und den Innenabschnitt des zylindrischen Schmelzgefäßes verändert, und zwar von einem quadratischen Querschnitt zu rechteckigen Querschnitten, deren kleinere Seite gleich der Seite des Quadrates ist.
